# EUROPEAN PATENT SPECIFICATION

(11) **EP 4 055 709 B1**
(45) Date of publication and mention of the grant of the patent: **26.03.2025**
(21) Application number: 19805157.5
(22) Date of filing: 08.11.2019
(51) Int. Cl.: H03F 1/42, H03F 3/195, H03F 3/68, H03F 3/72, H03G 3/00, H03F 3/08, H04B 10/69

(54) **HIGH SENSITIVITY 10G BURST MODE AMPLIFIER**
HOCHEMPFINDLICHER 10G BURST-MODE-VERSTÄRKER
AMPLIFICATEUR EN MODE RAFALE DE 10G À HAUTE SENSIBILITÉ

(43) Date of publication of application: 14.09.2022
(73) Proprietor: Huawei Technologies Co., Ltd., Shenzhen, Guangdong 518129 (CN)
(72) Inventor: EL BAHAR, Roni, 80992 Munich (DE); BEN AMRAM, Haim, 80992 Munich (DE)
(74) Representative: Körber, Martin Hans
(86) International application number: PCT/EP2019/080662
(87) International publication number: WO 2021/089168

(56) References cited:
- US-B2- 10 432 319
- FANG YA ET AL: "A 2.5-Gb/s CMOS optical receiver with wide dynamic range using dual AGCs", ANALOG INTEGRATED CIRCUITS AND SIGNAL PROCESSING, SPRINGER NEW YORK LLC, US, vol. 101, no. 2, 16 September 2019 (2019-09-16), pages 229 - 235, XP036908596, ISSN: 0925-1030, [retrieved on 20190916], DOI: 10.1007/S10470-019-01538-3

## Description

### BACKGROUND

The present invention, in some embodiments thereof, relates to a burst mode amplifier for a passive optical network, and in particular, but not exclusively, to a burst mode transimpedance amplifier with a combined architecture suitable for both high gain and adaptive gain.

Passive optical networks have become a widespread tool in connecting multiple users to an internet server. In a passive optical network, the signal sent from a customer's terminal, known as an optical network unit (ONU) to a central office, known as the optical line terminal (OLT), is a burst signal. Unlike the continuous signals widely used with Ethernet and other technologies, burst signals are multiple data segments (bursts) with a gap in between bursts, allowing burst receiver to acquire the threshold every single burst. Moreover, the distances from customers to the central office vary, which affects the signal strength. For the central office to be able to handle such customer data, these optical burst signals with differing strengths and timings must be converted into electrical signals of fixed strength and timing.

Upstream transmissions in a passive optical network follow a time division multiple access (TDMA) format. Each active optical network unit sends bursts toward the optical line terminal within precisely assigned time slots. The optical fibers from multiple optical network unites are merged into a single optical fiber using a power splitter which is connected to the central station. The length of optical fibers between the optical network units and the power splitter varies. Consequently, the intensities of the optical signals are not uniform. The burst mode receiver must process optical bursts from all active optical network units with different optical power levels, and unpredictable burst-to-burst phase. In particular, the burst mode receiver must be able to maintain high dynamic range (weak signal followed by strong signal and vice versa) of at least 20dB. By a rigorous time-ranging process, time division multiplexed passive optical networks avoid the collision of bursts and provide high bandwidth efficiency.

A typical burst-mode receiver for an optical line terminal consists of an avalanche photodiode (APD), which converts the optical signal into an electrical current signal; a transimpedance amplifier (TIA), which amplifies and converts the current signal into a voltage signal; a limiting amplifier (LA), which converts weak and strong voltages into fixed-amplitude voltage signals and performs offset compensation; and a clock and data recovery (CDR), which extracts the timing clock from this signal and reshapes the signal waveform using the extracted clock signal.

FANG YA ET AL: "A 2.5-Gb/s CMOS optical receiver with wide dynamic range using dual AGCs", ANALOG INTEGRATED CIRCUITS AND SIGNAL PROCESSING (2019), vol. 101, pages 229-235 discloses an optical receiver with wide dynamic range. As the input stage of the proposed optical receiver, a transimpedance amplifier of a three-cascaded inverting topology with a feedback resistor incorporates dual automatic gain controls to broaden the input dynamic range.

### SUMMARY

An ideal passive optical network deployment requires not only a high receiver sensitivity, but also a wide dynamic range. The dynamic range allows to handle differential optical distribution network losses that individual optical network unit bursts experience along the different optical paths. In burst mode receivers that are currently known, the transimpedance amplifier (TIA) input signal supports a dynamic range of approximately 20 to 25dB. This dynamic range corresponds to the 10G-EPON IEEE 802.3av standard, which specifies a dynamic range of 22 dB. In some passive optical networks, however, the received data can vary by a much larger range, for example up to 60dB. This corresponds to approximately a variance of 1,000:1 between the lowest and highest signal levels.

One reason for the limitation in dynamic range in known burst mode receivers is their method for controlling the gain. Standard burst mode receivers operate based on a "continuous" automatic gain control (AGC) approach. In a receiver with continuous Automatic Gain Control, a gain control signal tracks the average of the input signal power so that it can tolerate fluctuations in the power. However, a continuous automatic gain control system cannot support a dynamic range larger than 20-25 dB, and certainly not up to 60 dB. This is because, in continuous systems, a wider dynamic range comes at the expense of a longer settling time and shorter bandwidth.

In addition, in existing burst-mode receivers, the acquisition time for the receiver system, which is the time takes for the receiver circuit to settle to good output signal levels, is on the order of 100 nanoseconds. If faster acquisition time is needed, a reset signal needs to be generated by a Media Access Control (MAC) layer of the receiver. The MAC layer is located outside the chip containing the transimpedance amplifier.

For at least the foregoing reasons, a fast-acquisition, high dynamic range, high bandwidth, and low power burst-mode receiver is required, to support modern passive optical networks.

The foregoing and other objects are achieved by the features of the independent claims. The invention is defined in the independent claims. Advantageous features are defined in the dependent claims.

According to a first aspect, a burst mode receiver for a passive optical network includes a high gain circuitry portion having a plurality of cascaded amplifiers. Each of the cascaded amplifiers is configured to increase a gain of an input signal. The high gain circuitry portion also includes a plurality of high gain switches. The burst mode receiver further includes an adaptive gain circuitry portion having at least one inverter. The adaptive gain circuitry portion is configured to adaptively control the gain of the input signal. The adaptive gain circuitry portion further includes a plurality of adaptive gain switches. The high gain circuitry portion and the adaptive gain circuitry portion comprise a shared input portion comprising at least one metal oxide semiconductor transistor. When a peak detector detects input current in a first range, the burst mode receiver is configured to activate the high gain circuitry portion, in which the high gain switches are closed and the adaptive gain switches are opened, and when the peak detector detects input current in a second range, the burst mode receiver is configured to activate the adaptive gain circuitry portion, in which the high gain switches are opened and the adaptive gain switches are closed. The first range is between 3µA and 35µA and the second range is between 25µA and 3mA. Advantageously these ranges are well suited for maximizing the gain implemented by each of the architecture.

Advantageously, by using two different architectures configured to implement different gains, the receiver is able to receive bursts at a wide dynamic range. The dynamic range is not constrained to the dynamic range that would typically be available with a "continuous" automatic gain control (AGC) approach, but can also include dynamic range based on input current that is amplified with the high gain circuitry portion. Furthermore, the peak detector is integrated within the transimpedance amplifier, rather than in an external control, and the adaptive gain and high gain circuitry portions share an input portion. These integrated features allow for switching between the two architectures quickly and efficiently. The receiver is therefore able to receive bursts and operate the signals with a very short acquisition time.

In another implementation according to the first aspect, a dynamic range of the burst mode receiver is 60 dB. Advantageously, the receiver is thus capable of receiving bursts from a large number of optical network units, as well as optical network units at a large distance from the receiver.

In another implementation according to the first aspect, a sensitivity of the burst mode receiver is at least -33dBm, and a bit error ratio of the burst mode receiver is no greater than 10⁻⁴. Advantageously, the burst mode receiver combines low sensitivity with high accuracy.

In another implementation according to the first aspect, the peak detector monitors the input current of each burst and the burst mode receiver switches between the high gain circuitry portion and the adaptive gain circuitry portion within an acquisition time of fewer than 30 nanoseconds. Advantageously, this quick acquisition time allows for faster receipt of signals from different optical network units, thereby promoting efficiency of the entire passive optical network.

In another implementation according to the first aspect, the high gain circuitry portion includes three or more amplifiers. A first of the amplifiers is the transistor of the shared input portion. Each of the amplifiers is associated with a respective gain stage. Advantageously, the three amplifiers may thus be implemented as cascaded amplifiers, to thereby increase the gain of the high gain circuitry portion.

In another implementation according to the first aspect, the three respective gain stages are used to optimize noise, bandwidth, and gain performance of the input signal. Advantageously, for each amplifier, the adjustment to the gain may be selected based on desired values for noise and bandwidth.

In another implementation according to the first aspect, the high gain circuitry portion includes a feedback resistor and a feedback capacitor. Advantageously, the feedback resistor and capacitor are used to achieve a high gain using a large effective transconductance.

In another implementation according to the first aspect, the feedback resistor has a resistance of approximately 8.5K Ohm and the feedback capacitor has a capacitance of approximately 6 fF. Advantageously, a resistor and feedback capacitor with these values are effective for achieving stability high gain using a large effective transconductance.

In another implementation according to the first aspect, an input stage of the transimpedance amplifier comprises two inductors configured in series. Advantageously, the inductors help overcome the effects of parasitic capacitance on the high gain circuitry portion, such as parasitic capacitance resulting from proximity of transistors and an avalanche photodiode.

In another implementation according to the first aspect, the adaptive gain circuitry portion comprises a variable resistor and a variable capacitor. Advantageously, the resistance and capacitance of the variable resistor and variable capacitor may be adjusted with an automatic gain control loopback, in order to control the gain.

In another implementation according to the first aspect, the variable resistor is configured to have a resistance between approximately 40 and 400 Ohm and the variable capacitor is configured to have a capacitance between approximately 6 and 15 fF. Advantageously, these ranges of values enable the adaptive gain circuitry portion to implement a gain within desired ranges.

In another implementation according to the first aspect, the inverter is complementary metal oxide semiconductor (CMOS) push-pull inverter. Advantageously, a CMOS push-pull inverter operates with better noise behavior than alternative structures, such as a common-source amplifier, and thus is well suited for use in the adaptive gain circuitry portion.

In another implementation according to the first aspect, the burst mode receiver is configured to deliver data from a plurality of optical network units to an optical line terminal of a passive optical network. Advantageously, the burst mode receiver thus is able to deliver data as part of a fiber-to-the-home portion of a passive optical network.

In another implementation according to the first aspect, the passive optical network comprises at least 32 optical network units. Advantageously, the burst mode receiver is configured to deliver and differentiate signals from a number of optical network units that are typically connected to a single optical line terminal.

In another implementation according to the first aspect, the high gain switches and adaptive gain switches are transistors. Advantageously, the transistors may function as switches with a high efficiency and low expenditure of energy.

According to a second aspect, a method includes detecting an input signal entering a burst mode receiver. The burst mode receiver includes: a high gain circuitry portion having a plurality of cascaded amplifiers, each of the cascaded amplifiers configured to increase a gain of the input signal, and a plurality of high gain switches. The burst mode receiver further includes an adaptive gain circuity portion comprising at least one inverter, the adaptive gain circuitry portion configured to adaptively control the gain of the input signal, and a plurality of adaptive gain switches. The high gain circuitry portion and adaptive gain circuitry portion comprise a shared input portion comprising at least one metal oxide semiconductor transistor. The method includes, when a peak detector detects an input current in a first range, activating the high gain circuitry portion, in which the high gain switches are closed and the adaptive gain switches are opened. The method further includes, when the peak detector detects an input current in a second range, activating the adaptive gain circuitry portion, in which the high gain switches are opened and the adaptive gain switches are closed.

Advantageously, the method uses a burst mode receiver that combines two architectures for a trans-impedance amplifier into one circuit. By using two different architectures configured to implement different gains, the receiver is able to receive bursts at a wide dynamic range. The dynamic range is not constrained to the dynamic range that would typically be available with a "continuous" automatic gain control approach, but can also include dynamic range based on input current that is amplified with the high-gain circuitry portion. Furthermore, the peak detector is integrated within the transimpedance amplifier, rather than in an external control, and the adaptive gain and high gain circuitry portions share an input portion. These integrated features allow for switching between the two architectures quickly and efficiently. The receiver is therefore able to receive bursts and operate the signals with a very short acquisition time.

In another implementation according to the second aspect, the detecting step includes detecting current with a dynamic range of 60 dB. Advantageously, the method thus is suitable for receiving bursts from a large number of optical network units, as well as optical network units at a large distance from the receiver.

In another implementation according to the second aspect, the method further includes performing the detecting step with a peak detector that monitors the input current of each burst and switches between the first and second states within an acquisition time of fewer than 30 nanoseconds. Advantageously, this quick acquisition time allows for faster receipt of signals from different optical network units, thereby promoting efficiency of the entire passive optical network.

In another implementation according to the second aspect, the method further includes, when the detecting step detects an input signal between 3 µA and 35µA, activating the high gain circuitry; and when the detecting step detects an input signal between 25µA and 3 mA, activating the adaptive gain circuitry. Advantageously, these ranges are well-suited for maximizing the gain implemented by each of the architectures.

In another implementation according to the second aspect, the adaptive gain circuitry comprises a variable resistor and a variable capacitor, and the method further comprises adjusting the resistance of the variable resistor and the capacitance of the variable capacitor to thereby adaptively control the gain. Advantageously, the gain may thereby be controlled effectively.

In another implementation according to the second aspect, the method further includes delivering data from a plurality of optical network units to an optical line terminal through the burst mode receiver. Advantageously, the method is usable to deliver data as part of a fiber-to-the-home portion of a passive optical network.

In another implementation according to the second aspect, the delivering step comprises delivering data from at least 32 optical network units. Advantageously, the method is usable for delivering signals from a number of optical network units that are typically connected to a single optical line terminal.

Unless otherwise defined, all technical and/or scientific terms used herein have the same meaning as commonly understood by one of ordinary skill in the art to which the invention pertains. Although methods and materials similar or equivalent to those described herein can be used in the practice or testing of embodiments of the invention, exemplary methods and/or materials are described below. In case of conflict, the patent specification, including definitions, will control. In addition, the materials, methods, and examples are illustrative only and are not intended to be necessarily limiting.

### BRIEF DESCRIPTION OF THE SEVERAL VIEWS OF THE DRAWINGS

Some embodiments of the invention are herein described, by way of example only, with reference to the accompanying drawings. With specific reference now to the drawings in detail, it is stressed that the particulars shown are by way of example and for purposes of illustrative discussion of embodiments of the invention. In this regard, the description taken with the drawings makes apparent to those skilled in the art how embodiments of the invention may be practiced.

In the drawings:
FIG. 1 is a schematic diagram illustrating components of a transimpedance amplifier chip, in accordance with embodiments of the present invention;
FIG. 2 is a block diagram of a high gain portion of a burst mode transimpedance amplifier, in accordance with embodiments of the present invention;
FIG. 3 is a block diagram of an adaptive gain portion of a burst mode transimpedance amplifier, in accordance with embodiments of the present invention;
FIG. 4 is a block diagram of a burst mode transimpedance amplifier including a high gain portion and adaptive gain portion, with the high gain portion active, in accordance with embodiments of the present invention;
FIG. 5 is a block diagram of a burst mode transimpedance amplifier including a high gain portion and an adaptive gain portion, with the adaptive gain portion active, in accordance with embodiments of the present invention;
FIG. 6 is a schematic representation of components of a burst mode receiver, in accordance with embodiments of the present invention; and
FIG. 7 is a schematic representation of a passive optical network incorporating the burst mode amplifier, according to embodiments of the present invention.

### DETAILED DESCRIPTION

The invention is defined by the appended independent claim and the preferred embodiments are defined by the appended dependent claims.

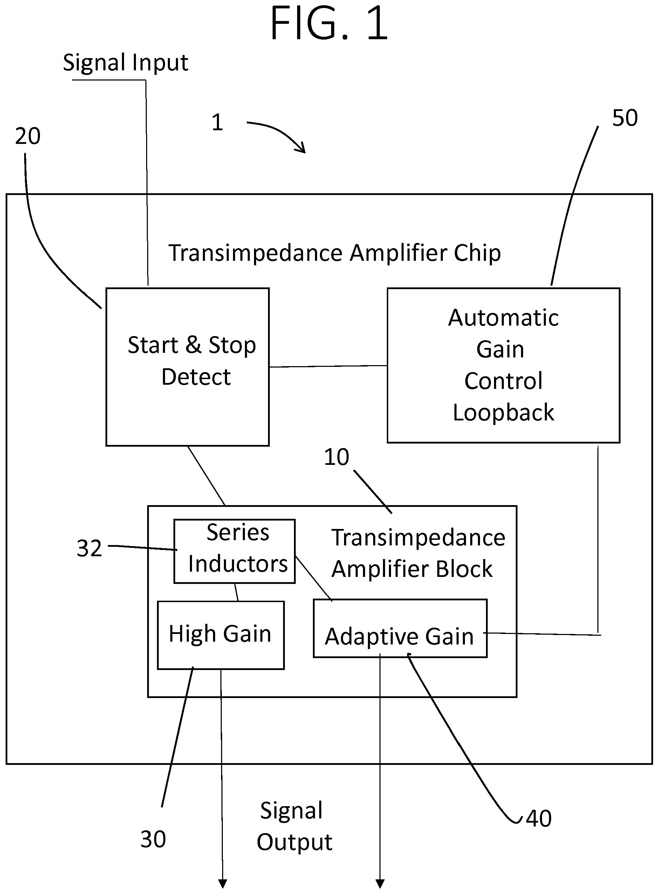

Referring now to FIG. 1, a schematic illustration of a transimpedance amplifier (TIA) chip 1 is disclosed. Chip 1 is part of a burst mode receiver. The TIA chip 1 includes TIA block 10, start & stop detector 20, and automatic gain control loopback 50. The TIA block 10 further includes high gain circuitry portion 30 and adaptive gain circuitry portion 40.

When a signal is delivered to the TIA chip 1, the Start Detector portion of the start & stop detector 20, also referred to herein as a peak detector, senses the input current received by the TIA block 10. The peak detector is operatively connected to a plurality of switches on the TIA block 10. Depending on the amplitude of the received signal, the peak detector operates the switches to route the signal through high gain circuitry portion 30 or adaptive gain circuitry portion 40. The amplified signal is then output from the TIA block 10.

Automatic gain control loopback 50 is used to provide an even output signal when the signal is routed through adaptive gain circuitry portion 40, as will be discussed further below.

After amplification and delivery of the signal, the stop detector portion of the start & stop detector 20 resets the peak detector, to prepare the start & stop detector 20 for receipt of a new signal.

The use of a start & stop detector 20 on TIA chip 1 differs from signal detectors used in standard burst mode transimpedance amplifiers. In a standard burst mode TIA, a reset signal is provided by a Media Access Control (MAC) chip, which is external to the TIA chip. In such devices, the reset signal sets Start-of-Burst and Stop-of-Burst timing and controls the automatic gain control mechanism. By contrast, in the depicted embodiments, the reset signal is generated from within TIA chip 1. This different design requires a more complex design of the TIA chip 1, but also enables a faster acquisition time for each signal. As used in this disclosure, acquisition time refers to the time that is necessary for the TIA to acquire a new coming burst. In devices with a reset signal based in a MAC chip, the average reset time is around hundreds of nanoseconds (ns). By contrast, in the burst mode amplifier of embodiments disclosed herein, the acquisition time is only around 30 ns.

The TIA block 10 also includes at its input portion two or more inductors 32 connected in series, the function of which will be explained below.

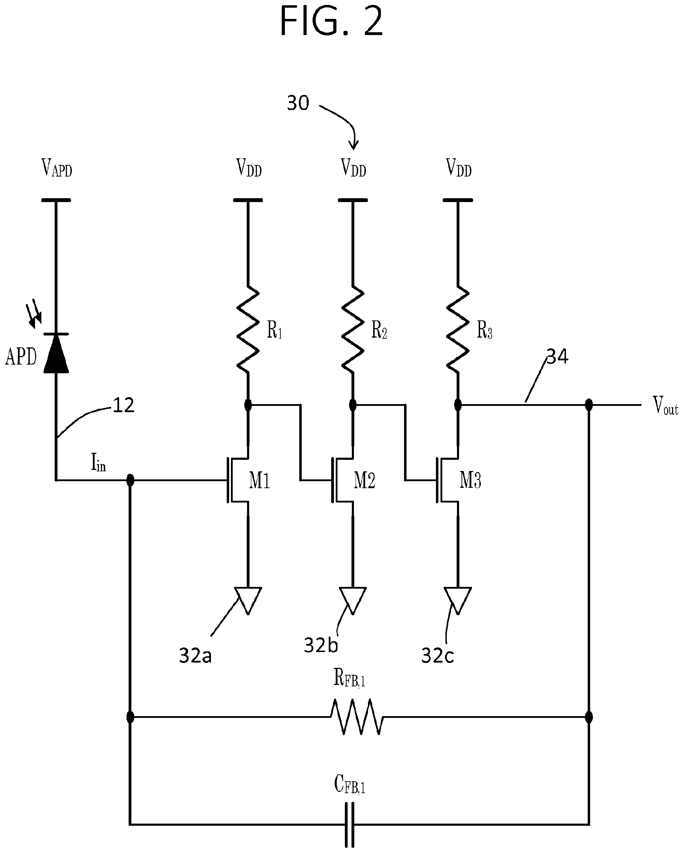

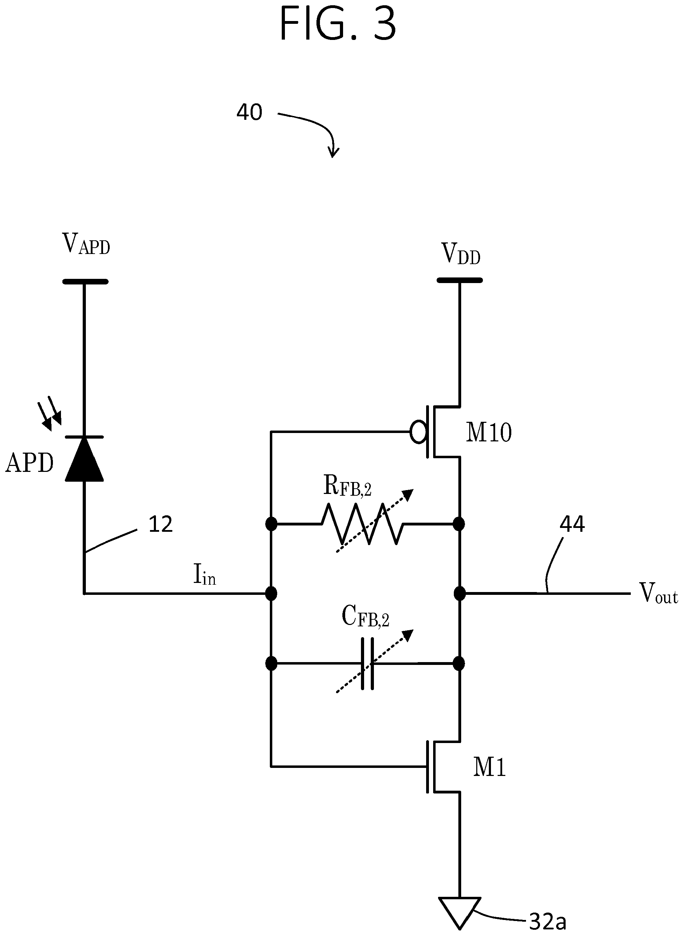

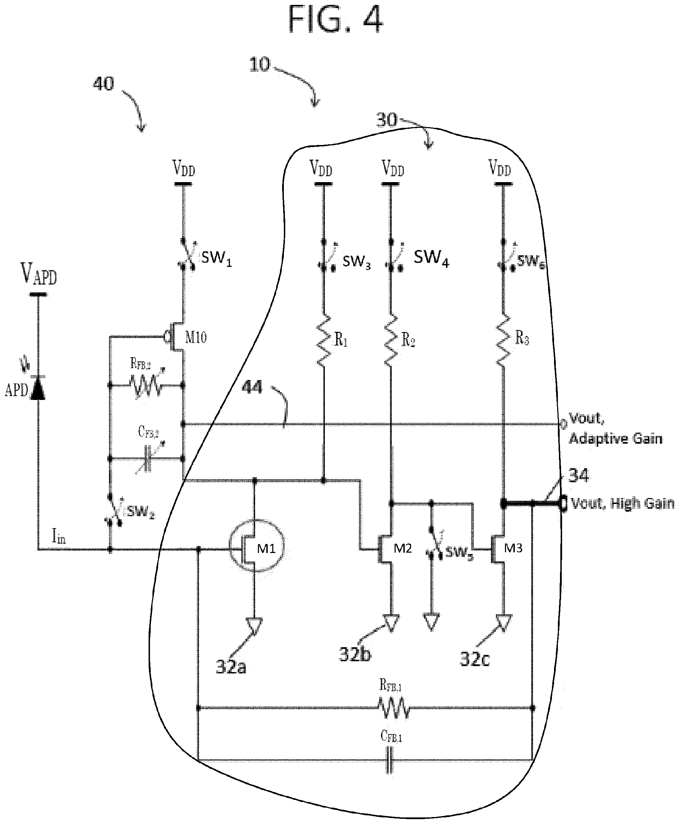

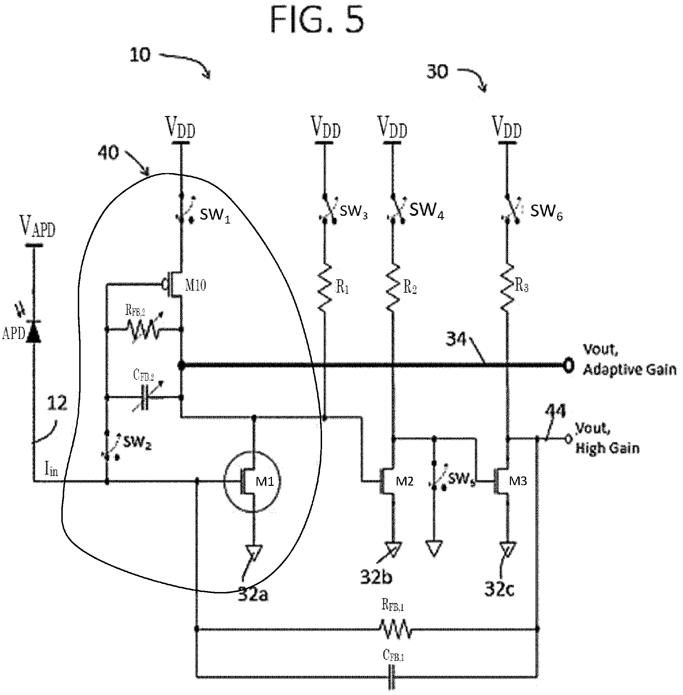

FIGS. 2-5 are block diagrams of the high gain circuitry portion 30 (FIG. 2), the adaptive gain circuitry portion 40 (FIG. 3), and a combined circuitry portion incorporating both the high gain circuitry portion 30 and the adaptive gain circuitry portion 40 (FIGS. 4 and 5).

Referring to FIG. 2, high gain circuitry portion 30 includes three transistors M1, M2, M3 arranged in series. In the depicted embodiment, transistors M1, M2, M3 are represented as metal oxide semiconductor field effect transistors (MOSFETs). In an exemplary embodiment, at least transistor M1 is a n-type metal oxide semiconductor (NMOS) Each transistor M1, M2, M3 is connected to a respective resistor R₁, R₂, R₃, and a respective amplifier 32a, 32b, 32c. In an exemplary embodiment, amplifiers 32a, 32b, and 32c are common source amplifiers. High gain circuitry portion further includes feedback resistor R_{FB1} and feedback capacitor C_{FB1}.

In operation of high gain circuitry portion 30, a signal is input through avalanche photodiode APD. Avalanche photodiode APD is a semiconductor electronic device that exploits the photoelectric effect to convert an optical signal from an optical network unit to electricity. The outputted electric signal proceeds along input trace 12 to each of the transistors M1, M2, and M3. Amplifiers 32a, 32b, and 32c are connected in series as cascade amplifiers. A cascade amplifier is a network constructed from a series of amplifiers, where each amplifier sends its output to the input of the next amplifier. The three stages of cascaded amplifiers provide very large gain and low noise. The large gain results from the high output impedance of the input transistor M1, and the low noise is achieved because the spectral intensity noise for a MOSFET transistor is lower than that of a corresponding resistor. The amplified signal is output from the high gain circuitry portion on output trace 34.

The feedback resistor R_{FB1} and the feedback capacitor C_{FB1} are used to control the gain and bandwidth of the signal that is output from high gain portion 30. The capacitance of capacitor C_{FB1} and the resistance of resistor R_{FB1} are fixed. In an exemplary embodiment, the resistance of the feedback resistor R_{FB1} is 8.5 KOhm and the capacitance of the feedback capacitor C_{FB1} is 6 fF.

Parasitic capacitance may limit the bandwidth of the high gain circuitry portion 30. In particular, transistors M1-M3 and avalanche photodiode APD may induce parasitic capacitance. To overcome this effect, two inductors 32 in series are included in the input stage of the TIA block 10 (as seen schematically in FIG. 1).

The gain stages in high gain circuitry portion 30 are used to optimize noise, bandwidth, and gain performances. The values for noise, bandwidth, and gain are all dependent on each other, as the following discussions and formulas demonstrate:
- Gain is a function of resistance in feedback resistor R_{FB1}. Changing the gain is effected by changing the resistance in the feedback resistor. The output amplitude is a function of the formula Amplitude = R*Iᵢₙ, where R is the resistance in Ohms, and Iᵢₙ is the input current in Amperes.
- Bandwidth is determined by the formula BW = 1/ (2*π*R*C), where R is the resistance of resistor R_{FB1} and C is the capacitance of capacitor C_{FB1}. Thus, the bandwidth is inversely proportional to the resistance.
- Noise is determined by the formula E² = 4*k*T*BW*R, where E is the root mean square noise voltage, k is Boltzmann's constant (1.38*10⁻²³ J/K), T is the absolute temperature in K, BW is the bandwidth in Hertz, and R is the resistance in Ohms). Thus, noise is proportional to the square root of the resistance and of the bandwidth.

Thus, if the resistance is high, the bandwidth is low, which leads to the noise being low. If resistance is low, the bandwidth is high, and the noise is high. Setting the resistance thus involves a trade-off between optimizing for low noise and optimizing for high bandwidth.

Referring now to FIG. 3, adaptive gain circuitry portion 40 includes, as in high gain circuitry portion 30, avalanche photodiode APD, input trace 12, and transistor M1. Transistor 1 is connected to amplifier 32a. These elements function in the same way that they do in high gain circuitry portion 30.

In addition, adaptive gain circuitry portion 40 includes inverter transistor M10. Inverter transistor M10 is a single stage complementary metal oxide semiconductor (CMOS) push pull inverter. In an exemplary embodiment, inverter transistor M10 is an p-type metal oxide semiconductor (PMOS). Thus, the combination of NMOS transistor M1 with PMOS transistor M10 forms an inverter gate. Transistors M1 and M10 are biased in their saturation regions to maximize the transconductance and increase the gain bandwidth product of the entire structure of adaptive gain circuitry portion 40.

The resistance of variable feedback resistor R_{FB2} and the capacitance of variable capacitor C_{FB2} are controlled by the automatic gain control loopback 50 (shown in FIG.1). Automatic gain control loopback 50 is a closed-loop feedback regulating circuit, the purpose of which is to maintain a stable signal amplitude at the output of the adaptive gain circuitry portion 40, despite variation of the signal amplitude at the input. The average or peak output signal level is used by the automatic gain control loopback 50 to dynamically adjust the resistance of resistor R_{FB2} and the capacitance of variable capacitor C_{FB2}, thereby correspondingly adjusting the gain. Optionally, there may be more than one automatic gain control loopback 50. The different automatic gain controls may be used for different gains within the adaptive gain circuitry portion 40, with each automatic gain control signal being active for a different input value.

In an exemplary embodiment, the resistance of resistor R_{FB2} ranges from 40 to 400 Ohm, and the capacitance of capacitor C_{FB2} ranges from 6 femtoFarad (fF) to 15 fF. Such values for resistance and capacitance are suitable for optimizing the gain to fit input signal pulses of approximately 25 uA to 3mA.

Reference is now made to FIGS. 4 and 5, in which high gain circuitry portion 30 and adaptive gain circuitry portion 40 are combined into a single architecture with a shared input portion. As in the embodiment of FIG. 2, high gain circuitry portion 30 has a plurality of cascaded amplifiers 32a-c. As in the embodiment of FIG. 3, adaptive gain portion 40 includes at least one inverter M10 and a variable feedback capacitor C_{FB2} and variable feedback resistor R_{FB2} controllable by automatic gain control loop 50.

Transistor M1 is circled in FIGS. 4 and 5 to indicate that it is activated in both the configuration of FIG. 4 and the configuration of FIG. 5. Thus, transistor M1 (which, in exemplary embodiments, is a metal oxide semiconductor transistor) is part of the shared input portion.

The architecture of FIGS. 4 and 5 further includes switches SW₁, SW₂, SW₃, SW₄, SW₅, and SW₆. The switches control whether the high gain portion 30 or the adaptive gain portion 40 is active. In the configuration of FIG. 4, switches SW₁, SW₂, and SW₅ are open, switches SW₃, SW₄, and SW₆ are closed, and the high gain circuitry portion 30 is active. To represent this status, the high gain circuitry portion 30 is indicated with a grey background, and the output trace 34 of the high gain portion 30 is indicated with a thicker line than the output trace 44 of adaptive gain portion 40. By contrast, in the configuration of FIG. 5, SW₁, SW₂, and SW₅ are closed, switches SW₃, SW₄, and SW₆ are open, and the adaptive gain circuitry portion 40 is active. To represent this status, the adaptive gain circuitry portion 40 is indicated with a grey background, and the output trace 44 of the adaptive gain portion 40 is indicated with a thicker line than the output trace 34 of high gain portion 40. As used in this disclosure, switches SW₁, SW₂, and SW₅ are collectively referred to as adaptive gain switches, because the adaptive gain portion 40 is activated when those switches are closed. Correspondingly, switches SW₃, SW₄, and SW₆ are collectively referred to as high gain switches, because the high gain portion 30 is activated when those switches are closed. In exemplary embodiments, both the high gain switches and the adaptive gain switches are transistors.

The peak detector (shown in FIG. 1) provides information for controlling the status of the high gain switches and the adaptive gain switches. When a burst-mode signal is input to the peak detector, the peak detector detects the current of the input signal. An input current sensing algorithm evaluates each incoming burst. Based on the current of the input signal, the burst mode receiver determines whether the signal should be amplified using the high gain circuitry portion 30 or the adaptive gain circuitry portion 40. If the current is in a first range, the burst mode receiver closes the high gain switches and opens the adaptive gain switches, to thereby activate the high gain circuitry portion 30. If the detected current is in a second range, the burst mode receiver closes the adaptive gain switches and opens the high gain switches, to thereby activate the adaptive gain portion 40. This entire process takes place extremely quickly. In some embodiments, the peak detector monitors the input current of each burst, and the burst mode receiver switches between the high gain circuitry portion 30 and the adaptive gain circuitry portion 40, within an acquisition time of fewer than 30 ns.

In the claimed invention, the burst mode receiver receives signals with a dynamic range of between 3 µA and 3 mA. In such embodiments, the dynamic range of the burst mode receiver is 60 dB. The input current of the first range is between 3 and 35 µA, and the input current of the second range is between 25 µA and 3 mA. There is an overlap region of approximately 10 µA, in which the signal may be directed to either the high gain circuitry portion 30 or the adaptive gain circuitry portion 40. The hysteresis, or overlap, region is set as 10 µA. The overlap region is used because it is not realistic to switch at exactly one point along a spectrum of signal currents. The hysteresis region thus enables the burst mode receiver to make a better decision whether to activate the high gain circuitry portion 30 or the adaptive gain circuitry portion 40.

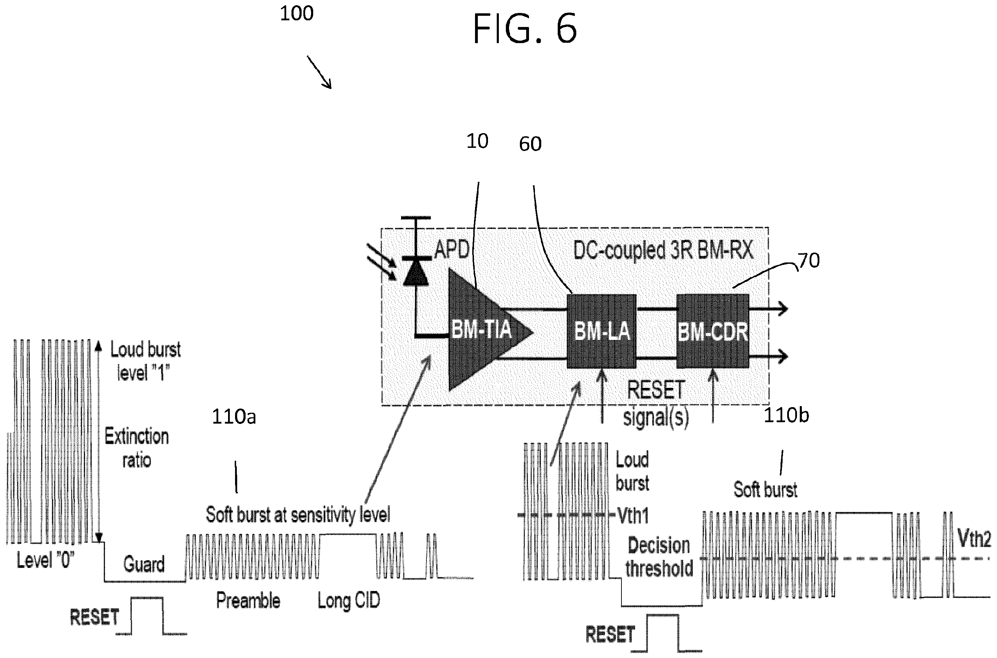

FIG. 6 is a schematic representation of a burst mode receiver 100, of which burst mode transimpedance amplifier 1 is a component. In addition to transimpedance amplifier 10, burst mode receiver 100 additionally includes burst mode limiting amplifier 60 and burst mode clock data recovery 70. The burst mode receiver 100 is used to amplify a soft burst signal 110a to an equivalent signal 110b with a larger amplitude. Each incoming burst has a different amplitude. To detect each part of the signal without errors, it is first necessary to detect the amplitude, and then to set a decision threshold at the middle of the burst's amplitude. Each portion of the amplified signal is then evaluated to see whether it is above the decision threshold (and should be assigned a "1" value) or below the decision threshold (and should be assigned a "0") value.

The burst mode receiver schematically represented in FIG. 6 complies with IEEE standard 802.03av, but improves over the performance of other receivers satisfying the IEEE 802.03av standard. In a standard burst mode receiver complying with standard 802.03av, the line rate is 10.315 Gbps, the dynamic range is 22dB, and the sensitivity is -28dBM with a bit error ratio of 1E-3. In burst mode receivers with the TIA chip of certain embodiments, the dynamic range is 60 dB, the sensitivity is -33dBm, and the bit error ratio is 1E-4. Thus, the dynamic range is greater, the sensitivity is lower, and the bit error ratio is lower.

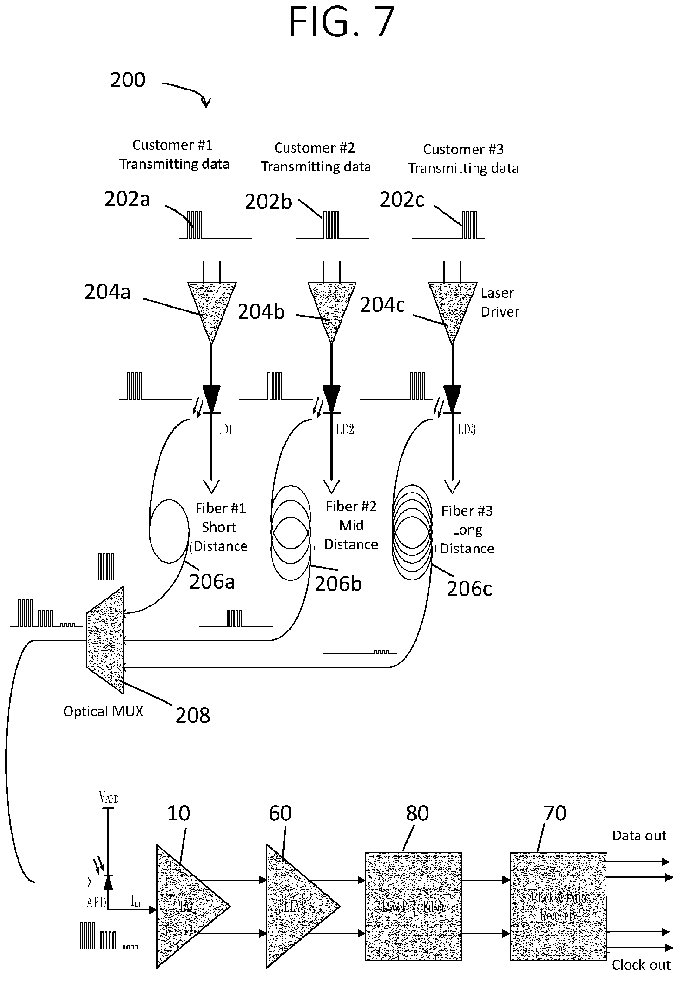

FIG. 7 is a schematic representation of a passive optical network 200 incorporating the burst mode receiver 100, according to embodiments of the present invention. In the illustrated embodiment, three customers at optical network units 202a, 202b, and 202c transmit data to an optical line terminal (OLT) (not shown) in a time division multiple access (TDMA) format. The number of customers could alternatively be 32, as is typically used in a passive optical network. Alternatively, the increased dynamic range enabled by the disclosed embodiments may allow the passive optical network to include additional customers at various distances from the optical line terminal, for example, double the number of typical customers. In addition or in the alternative, the distance between each optical network unit and the furthest customer may be doubled.

The electrical data generated by each optical network unit 202a-c is converted to optical data using laser drivers 204a-c and laser diodes LD1, LD2, and LD3.

Each customer is located at a different distance from the optical line terminal, as represented by the fibers 206a-206c of different lengths. Fiber 206a is a comparatively short distance from the optical line terminal; fiber 206b is a middle-range distance from the OLT, and fiber 206c is a long distance from the OLT. As a result, the signal is attenuated more along fiber 206c than along fiber 206b, and more along fiber 206b than fiber 206a. All of the optical data is then time multiplexed on optical multiplexer 208, and is transmitted from multiplexer 208 on a single optical fiber. The optical data burst is then converted into electrical current by avalanche photodiode APD. In some embodiments, the current Iᵢₙ has an amplitude ranging from 3uA for the remotest customer 206c to 3mA for the nearest customer 202a (-33dBm to -3dBm).

A TIA chip 10 includes a burst mode transimpedance amplifier which amplifies the electric signal. The passive optical network 200 further includes limiting amplifier 60, low pass filter 80, and clock & data recovery circuit 70. The low pass filter is used to reduce noises coming from high frequencies, e.g., frequencies above the working frequency. Data and clock information are then output to the optical line terminal.

In an exemplary embodiment, the data is uploaded upstream from the optical network units 202 to the optical line terminal at a wavelength 1310 nm, and downloaded from the optical line terminal to the optical network units at a wavelength1490 nm. These values are merely exemplary, and other values for the wavelength may similarly be used.

As used herein the term "about" refers to ± 10 %.

The terms "comprises", "comprising", "includes", "including", "having" and their conjugates mean "including but not limited to". This term encompasses the terms "consisting of" and "consisting essentially of".

The phrase "consisting essentially of" means that the composition or method may include additional ingredients and/or steps, but only if the additional ingredients and/or steps do not materially alter the basic and novel characteristics of the claimed composition or method.

As used herein, the singular form "a", "an" and "the" include plural references unless the context clearly dictates otherwise. For example, the term "a compound" or "at least one compound" may include a plurality of compounds, including mixtures thereof.

The word "exemplary" is used herein to mean "serving as an example, instance or illustration". Any embodiment described as "exemplary" is not necessarily to be construed as preferred or advantageous over other embodiments and/or to exclude the incorporation of features from other embodiments.

The word "optionally" is used herein to mean "is provided in some embodiments and not provided in other embodiments". Any particular embodiment of the invention may include a plurality of "optional" features unless such features conflict.

Throughout this application, various embodiments of this invention may be presented in a range format. It should be understood that the description in range format is merely for convenience and brevity and should not be construed as an inflexible limitation on the scope of the invention. Accordingly, the description of a range should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range.

Whenever a numerical range is indicated herein, it is meant to include any cited numeral (fractional or integral) within the indicated range. The phrases "ranging/ranges between" a first indicate number and a second indicate number and "ranging/ranges from" a first indicate number "to" a second indicate number are used herein interchangeably and are meant to include the first and second indicated numbers and all the fractional and integral numerals there between.

## Claims

1. A burst mode receiver (100) for a passive optical network, comprising:
(i) a high gain circuitry portion (30) having a plurality of cascaded amplifiers (32a-c), each of the cascaded amplifiers configured to increase a gain of an input signal, and a plurality of high gain switches (SW3, SW4, SW6); and
(ii) an adaptive gain circuitry portion (40) having at least one amplifying inverter comprising an p-type metal oxide semiconductor, PMOS, transistor (M10), the adaptive gain circuitry portion (40) configured to adaptively control the gain of the input signal, and a plurality of adaptive gain switches (SW1, SW2, SW5); and
wherein the high gain circuitry portion (30) and the adaptive gain circuitry portion (40) comprise a shared input portion comprising at least one n-type metal oxide semiconductor, NMOS, transistor (M1);
wherein the combination of PMOS transistor (M10) with NMOS transistor (M1) forms the amplifying inverter and a first amplifier (32a) of the plurality of cascaded amplifiers (32a-c) comprises the NMOS transistor (M1);
wherein, when a peak detector (20) detects input current in a first range, the burst mode receiver (100) is configured to activate the high gain circuitry portion (30) and de-activate the adaptive gain circuitry portion (40), in which the high gain switches (SW3, SW4, SW6) are closed and the adaptive gain switches (SW1, SW2, SW5) are opened, and when the peak detector detects input current in a second range, the burst mode receiver (100) is configured to activate the adaptive gain circuitry portion (40) and de-activate the high gain circuitry portion(30), in which the high gain switches (SW3, SW4, SW6) are opened and the adaptive gain switches (SW1, SW2, SW5) are closed; and
wherein the first range is between 3 µA and 35µA, and the second range is between 25µA and 3 mA comprising a hysteresis, or overlap, region of 10 µA.

2. The burst mode receiver of any of claim 1, wherein the high gain circuitry portion (30) comprises three or more amplifiers, wherein each of the amplifiers is associated with a respective gain stage.

3. The burst mode receiver of claim 1 or 2, wherein the high gain circuitry portion (30) comprises a feedback resistor (R_{FB1}) and a feedback capacitor (C_{FB1}).

4. The burst mode receiver of claim 3, wherein the feedback resistor (R_{FB1}) has a resistance of approximately 8.5 KOhm and the feedback capacitor (C_{FB1}) has a capacitance of approximately 6fF.

5. The burst mode receiver of any of claims 1 to 4, wherein an input stage of the transimpedance amplifier comprises two inductors configured in series.

6. The burst mode receiver of any of claims 1 to 5, wherein the adaptive gain circuitry portion (40) comprises a variable resistor (R_{FB2}) and a variable capacitor (C_{FB2}).

7. The burst mode receiver of claim 6, wherein the variable resistor (R_{FB2}) is configured to have a resistance between approximately 40 and 400 Ohm and the variable capacitor (C_{FB2}) is configured to have a capacitance between approximately 6 and 15 fF.

8. The burst mode receiver of any of claims 1 to 7, wherein the amplifying inverter is a complementary metal oxide semiconductor push-pull inverter.

9. The burst mode receiver of any of claims 1 to 8, wherein the burst mode receiver is configured to deliver data from a plurality of optical network units to an optical line terminal of a passive optical network.

10. The burst mode receiver of claim 9, wherein the passive optical network comprises at least 32 optical network units.

## Patentansprüche

1. Burst-Mode-Empfänger (100) für ein passives optisches Netzwerk, der umfasst:
(i) einen Hochleistungsschaltungsabschnitt (30), der eine Vielzahl von kaskadierten Verstärkern (32a-c), wobei jeder der kaskadierten Verstärker konfiguriert ist, um eine Leistung eines Eingangssignals zu erhöhen, und eine Vielzahl von Hochleistungsschaltern (SW3, SW4, SW6) aufweist; und
(ii) einen adaptiven Leistungsschaltungsabschnitt (40), der mindestens einen verstärkenden Inverter, der einen p-Typ-Metalloxidhalbleiter(PMOS)-Transistor (M10) umfasst, wobei der adaptive Leistungsschaltungsabschnitt (40) konfiguriert ist, um die Leistung des Eingangssignals adaptiv zu steuern, und eine Vielzahl von adaptiven Leistungsschaltern (SW1, SW2, SW5) aufweist; und
wobei der Hochleistungsschaltungsabschnitt (30) und der adaptive Leistungsschaltungsabschnitt (40) einen gemeinsamen Eingangsabschnitt umfassen, der mindestens einen n-Typ-Metalloxidhalbleiter(NMOS)-Transistor (M1) umfasst;
wobei die Kombination aus PMOS-Transistor (M10) und NMOS-Transistor (M1) den verstärkenden Inverter ausbildet und ein erster Verstärker (32a) der Vielzahl von kaskadierten Verstärkern (32a-c) den NMOS-Transistor (M1) umfasst;
wobei, wenn ein Spitzendetektor (20) einen Eingangsstrom in einem ersten Bereich erkennt, der Burst-Modus-Empfänger (100) konfiguriert ist, um den Hochleistungsschaltungsabschnitt (30) zu aktivieren und den adaptiven Leistungsschaltungsabschnitt (40) zu deaktivieren, wobei die Hochleistungsschalter (SW3, SW4, SW6) geschlossen sind und die adaptiven Leistungsschalter (SW1, SW2, SW5) geöffnet sind, und wenn der Spitzendetektor einen Eingangsstrom in einem zweiten Bereich erkennt, der Burst-Modus-Empfänger (100) konfiguriert ist, um den adaptiven Leistungsschaltungsabschnitt (40) zu aktivieren und den Hochleistungsschaltungsabschnitt (30) zu deaktivieren, wobei die Hochleistungsschalter (SW3, SW4, SW6) geöffnet sind und die adaptiven Leistungsschalter (SW1, SW2, SW5) geschlossen sind; und
wobei der erste Bereich zwischen 3 µA und 35 µA liegt und der zweite Bereich zwischen 25 µA und 3 mA liegt, wobei sie einen Hysterese- oder Überlappungsbereich von 10 µA umfassen.

2. Burst-Mode-Empfänger nach Anspruch 1, wobei der Hochleistungsschaltungsabschnitt (30) drei oder mehr Verstärker umfasst,
wobei jeder der Verstärker einer jeweiligen Leistungsstufe zugeordnet ist.

3. Burst-Mode-Empfänger nach Anspruch 1 oder 2, wobei der Hochleistungsschaltungsabschnitt (30) einen Rückkopplungswiderstand (RFB1) und einen Rückkopplungskondensator (CFB1) umfasst.

4. Burst-Mode-Empfänger nach Anspruch 3, wobei der Rückkopplungswiderstand (RFB1) einen Widerstand von etwa 8,5 KOhm aufweist und der Rückkopplungskondensator (CFB1) eine Kapazität von etwa 6fF aufweist.

5. Burst-Mode-Empfänger nach einem der Ansprüche 1 bis 4, wobei eine Eingangsstufe des Transimpedanzverstärkers zwei in Reihe konfigurierte Induktoren umfasst.

6. Burst-Mode-Empfänger nach einem der Ansprüche 1 bis 5, wobei der adaptive Leistungsschaltungsabschnitt (40) einen variablen Widerstand (RFB2) und einen variablen Kondensator (CFB2) umfasst.

7. Burst-Mode-Empfänger nach Anspruch 6, wobei der variable Widerstand (RFB2) konfiguriert ist, um einen Widerstand zwischen etwa 40 und 400 Ohm aufzuweisen und der variable Kondensator (CFB2) konfiguriert ist, um eine Kapazität zwischen etwa 6 und 15 fF aufzuweisen.

8. Burst-Mode-Empfänger nach einem der Ansprüche 1 bis 7, wobei der verstärkende Inverter ein komplementärer Metalloxidhalbleiter-Gegentaktinverter ist.

9. Burst-Modus-Empfänger nach einem der Ansprüche 1 bis 8, wobei der Burst-Modus-Empfänger konfiguriert ist, um Daten von einer Vielzahl von optischen Netzwerkeinheiten an ein optisches Leitungsendgerät eines passiven optischen Netzwerks zu liefern.

10. Burst-Modus-Empfänger nach Anspruch 9, wobei das passive optische Netzwerk mindestens 32 optische Netzwerkeinheiten umfasst.

## Revendications

1. Récepteur en mode rafale (100) pour un réseau optique passif, comprenant :
(i) une partie de circuits à gain élevé (30) ayant une pluralité d'amplificateurs en cascade (32a à c), chacun des amplificateurs en cascade étant configuré pour augmenter un gain d'un signal d'entrée, et une pluralité de commutateurs à gain élevé (SW3, SW4, SW6) ; et
(ii) une partie de circuits à gain adaptatif (40) ayant au moins un onduleur d'amplification comprenant un transistor à métal-oxyde-semiconducteur de type p, PMOS, (M10), la partie de circuits à gain adaptatif (40) étant configurée pour commander de manière adaptative le gain du signal d'entrée, et une pluralité de commutateurs à gain adaptatif (SW1, SW2, SW5) ; et
dans lequel la partie de circuits à gain élevé (30) et la partie de circuits à gain adaptatif (40) comprennent une partie d'entrée partagée comprenant au moins un transistor à métal-oxyde-semiconducteur de type n, NMOS, (M1) ;
dans lequel la combinaison du transistor PMOS (M10) avec le transistor NMOS (M1) forme l'onduleur d'amplification et un premier amplificateur (32a) de la pluralité d'amplificateurs en cascade (32a à c) comprend le transistor NMOS (M1) ;
dans lequel, lorsqu'un détecteur de crête (20) détecte un courant d'entrée dans une première plage, le récepteur en mode rafale (100) est configuré pour activer la partie de circuits à gain élevé (30) et désactiver la partie de circuits à gain adaptatif (40), dans lequel les commutateurs à gain élevé (SW3, SW4, SW6) sont fermés et les commutateurs à gain adaptatif (SW1, SW2, SW5) sont ouverts, et, lorsque le détecteur de crête détecte un courant d'entrée dans une seconde plage, le récepteur en mode rafale (100) est configuré pour activer la partie de circuits à gain adaptatif (40) et désactiver la partie de circuits à gain élevé (30), dans lequel les commutateurs à gain élevé (SW3, SW4, SW6) sont ouverts et les commutateurs à gain adaptatif (SW1, SW2, SW5) sont fermés ; et
dans lequel la première plage est comprise entre 3 µA et 35 µA, et la seconde plage est comprise entre 25 µA et 3 mA, comprenant une région d'hystérésis, ou de chevauchement, de 10 µA.

2. Récepteur en mode rafale selon la revendication 1, dans lequel la partie de circuits à gain élevé (30) comprend trois amplificateurs ou plus,
dans lequel chacun des amplificateurs est associé à un étage à gain respectif.

3. Récepteur en mode rafale selon la revendication 1 ou 2, dans lequel la partie de circuits à gain élevé (30) comprend une résistance de rétroaction (R_{FB1}) et un condensateur de rétroaction (C_{FB1}).

4. Récepteur en mode rafale selon la revendication 3, dans lequel la résistance de rétroaction (R_{FB1}) a une résistance d'environ 8,5 KOhm et le condensateur de rétroaction (C_{FB1}) a une capacité d'environ 6 fF.

5. Récepteur en mode rafale selon l'une quelconque des revendications 1 à 4, dans lequel un étage d'entrée de l'amplificateur à transimpédance comprend deux inductances configurées en série.

6. Récepteur en mode rafale selon l'une quelconque des revendications 1 à 5, dans lequel la partie de circuits à gain adaptatif (40) comprend une résistance variable (R_{FB2}) et un condensateur variable (C_{FB2}).

7. Récepteur en mode rafale selon la revendication 6, dans lequel la résistance variable (R_{FB2}) est configurée pour avoir une résistance comprise entre environ 40 et 400 Ohm et le condensateur variable (C_{FB2}) est configuré pour avoir une capacité comprise entre environ 6 et 15 fF.

8. Récepteur en mode rafale selon l'une quelconque des revendications 1 à 7, dans lequel l'onduleur d'amplification est un onduleur push-pull à métal-oxyde-semiconducteur complémentaire.

9. Récepteur en mode rafale selon l'une quelconque des revendications 1 à 8, dans lequel le récepteur en mode rafale est configuré pour fournir des données à partir d'une pluralité d'unités de réseau optique à un terminal de ligne optique d'un réseau optique passif.

10. Récepteur en mode rafale selon la revendication 9, dans lequel le réseau optique passif comprend au moins 32 unités de réseau optique.
